# EUROPÄISCHE PATENTSCHRIFT

(11) **EP 4 637 033 B1**
(45) Veröffentlichungstag und Bekanntmachung des Hinweises auf die Patenterteilung: **03.06.2026**
(21) Anmeldenummer: 25163578.5
(22) Anmeldetag: 13.03.2025
(51) Int. Cl.: H03K 5/12, H03K 7/08, G01S 7/484, H01S 5/042, H01S 5/062, H03K 5/13, G01S 7/481

(54) **PULSERZEUGUNGSVORRICHTUNG, TREIBERSCHALTUNG UND PULSERZEUGUNGSVERFAHREN**
PULSE GENERATING DEVICE, DRIVING CIRCUIT, AND PULSE GENERATING METHOD
DISPOSITIF DE GÉNÉRATION D'IMPULSION, CIRCUIT DE COMMANDE ET PROCÉDÉ DE GÉNÉRATION D'IMPULSION

(30) Priorität: 15.04.2024 DE 102024110514
(43) Veröffentlichungstag der Anmeldung: 22.10.2025
(73) Patentinhaber: SICK AG, 79183 Waldkirch (DE)
(72) Erfinder: BALDISCHWEILER, Boris, 79194 Gundelfingen (DE)
(74) Vertreter: Manitz Finsterwald Patent- und Rechtsanwaltspartnerschaft mbB

(56) Entgegenhaltungen:
- CN-A- 115 454 168
- DE-A1- 102013 212 702
- DE-A1- 102017 127 505

## Beschreibung

Die vorliegende Erfindung betrifft eine Pulserzeugungsvorrichtung zur Erzeugung von Ausgangspulsen mit Pulsdauern im Bereich von Nanosekunden oder kürzer, eine Treiberschaltung und ein Pulserzeugungsverfahren.

Eine Pulserzeugungsvorrichtung ist eine elektrische oder elektronische Schaltung, die elektronische Pulse einer definierten Dauer erzeugt. Gegenstand dieser Anmeldung sind vor allem Pulsdauern im Bereich von Nanosekunden, beispielsweise einstelligen Nanosekunden, oder kürzer. Derartig kurze Pulse werden beispielsweise bei der Erzeugung von Laserpulsen verwendet. Dabei ist eine hohe Genauigkeit wünschenswert.

Pulserzeugungsvorrichtungen können auf unterschiedlichen technischen Prinzipien beruhen. In dieser Anmeldung werden Pulserzeugungsvorrichtungen, die auf einer Verzögerungsleitung, einer sogenannten delay line, basieren, betrachtet. Die Verzögerungsleitung stellt einen an sie angelegten elektrischen Impuls aufgrund der Signallaufzeit des Pulses über die Leitung nach einer definierten Verzögerung an ihrem Ausgang bereit. Diese Signallaufzeit unterliegt unter anderem thermischen Schwankungen, da sich die elektrische Leitfähigkeit mit der Temperatur verändert. Mit einer 30cm langen Verzögerungsleitung wird beispielsweise eine Verzögerung von zwei Nanosekunden erzeugt. Eine Änderung der Temperatur der Verzögerungsleitung um 100 Kelvin verändert die Verzögerung beispielsweise um 100 Pikosekunden, was in etwa fünf Prozent des Nennwerts von zwei Nanosekunden entspricht.

Die aus dem Stand der Technik bekannten Verzögerungsleitungen begegnen diesen Temperaturdrifts in gewissem Maße, es bleibt jedoch oft eine Unsicherheit im Bereich von mehreren 100 Pikosekunden. Dies ist auch im Hinblick auf den im Bereich der Laserleistungsklassen geforderten Augenschutz meist nicht ausreichend. Die Leistung des Lasers, welcher in seiner Ansteuerung einen verzögerungsleitungsbasierten Treiber enthält, muss deshalb reduziert werden. Eine reduzierte Laserleistung verringert jedoch die Messgenauigkeit.

DE 10 2017 127505 A1 beschreibt eine Pulserzeugungsvorrichtung zur Erzeugung eines Spannungspulses, bei der die Pulsdauer des Ausgangspulses über die Veränderung der Position eines Reflexionsmittels innerhalb einer Verzögerungsleitung reguliert wird. DE 10 2013 212702 A1 zeigt eine optoelektronische Schaltung zur Übertragung eines optischen Taktsignals an ein elektronisches Bauelement, wobei die Schaltung dazu ausgebildet ist, die Verzögerungszeit einer optischen Verzögerungsleitung über die Beheizung der optischen Leitung mittels eines Heizelements einzustellen. CN 115 454 168 A diskutiert ein Verfahren zum Sanftanlauf eines Laser-Temperaturregelungssystems, bei welchem die Lasertemperatur über ein thermoelektrisches Kühl-/Heizelement geregelt wird.

Es besteht die Möglichkeit, die temperaturabhängige Unsicherheit von Verzögerungsleitungen mit Hilfe eines Temperaturcontrollers und eines Peltier-Elements zu überwinden. Der hierfür notwendige schaltungstechnische Aufwand verteuert und vergrößert jedoch die Gesamtlösung.

Eine Aufgabe der vorliegenden Erfindung besteht folglich darin, eine gegenüber dem bekannten Stand der Technik verbesserte Pulserzeugungsvorrichtung anzugeben, vor allem im Hinblick auf die thermischen Eigenschaften.

Die Aufgabe wird gelöst durch die Pulserzeugungsvorrichtung des Anspruchs 1, sowie durch das Pulserzeugungsverfahren des Anspruchs 11. Weiterbildungen und Ausgestaltungen sind in den abhängigen Patentansprüchen definiert.

In einer Ausführungsform weist eine Pulserzeugungsvorrichtung zur Erzeugung von Ausgangspulsen mit Pulsdauern im Bereich von Nanosekunden oder kürzer eine Signalquelle, eine mit der Signalquelle gekoppelte Pulsverkürzungsschaltung und eine mit der Pulsverkürzungsschaltung gekoppelte Heizquelle auf. Die Signalquelle ist zum Bereitstellen eines Eingangsstroms, welcher Eingangspulse einer Eingangspulsdauer umfasst, eingerichtet. Die Pulsverkürzungsschaltung weist eine Verzögerungsleitung auf und ist zum Bereitstellen der Ausgangspulse auf Basis des Eingangsstroms eingerichtet. Dabei ist eine Pulsdauer der Ausgangspulse kürzer als die Eingangspulsdauer. Die Heizquelle ist zum Bereitstellen eines Heizstroms für die Verzögerungsleitung der Pulsverkürzungsschaltung eingerichtet. Die Verzögerungsleitung ist zum Aufheizen auf eine zumindest im wesentlichen konstante Betriebstemperatur unter Verwendung des Heizstroms ausgelegt.

In der erfindungsgemäßen Pulserzeugungsvorrichtung werden zugeführte Eingangspulse mithilfe der Verzögerungsleitung der Pulsverkürzungsschaltung verkürzt und als Ausgangspulse bereitgestellt. Die Heizquelle heizt die Verzögerungsleitung auf eine zumindest im Wesentlichen konstante Betriebstemperatur auf. Die Verzögerungsleitung oder delay line wird also erfindungsgemäß sowohl zur Verzögerung von Eingangspulsen, als auch zeitgleich als Heizelement verwendet. Dadurch wird die Verzögerungsleitung bei einer nahezu konstanten Temperatur, beispielsweise mit einer Abweichung von lediglich 0,5 Prozent betrieben, wodurch temperaturbedingte Änderungen in der Pulsdauer der Ausgangspulse, die auch durch andere Umwelteinflüsse wie Feuchtigkeit verursacht sein können, vermieden werden. Die erfindungsgemäße Pulserzeugungsvorrichtung kann platzsparend und kostengünstig implementiert werden, da sie kein zusätzliches Peltier-Element oder einen Temperaturcontroller benötigt. Typische Pulsdauern der Ausgangspulse liegen im Bereich von einigen Nanosekunden, beispielsweise zwei Nanosekunden, bis hin zu Pikosekunden, etwa 100 Pikosekunden.

Die eingangs beschriebenen Definitionen gelten auch für den nachfolgenden Text, sofern nichts anderes angegeben ist.

Gemäß einer Weiterbildung ist eine Frequenz des Eingangsstroms höher als eine Frequenz des Heizstroms. Insbesondere umfasst die Heizquelle eine Gleichspannungsquelle oder eine Gleichstromquelle.

Die Frequenz des von der Signalquelle bereitgestellten Eingangsstroms ist damit höher, bevorzugt viel höher, beispielsweise um den Faktor 1000 und darüber, höher als die Frequenz des Heizstroms. In einer möglichen Realisierung der Erfindung ist die Heizquelle als Gleichstrom- oder Gleichspannungsquelle ausgeführt und erzeugt ein nahezu konstantes Gleichsignal. Im Gegensatz dazu erzeugt die Signalquelle einen gepulsten Eingangsstrom beispielsweise unter Verwendung eines Rechteckgenerators, eines field programmable gate arrays, FPGAs, oder eines Mikrocontrollers. Im Idealfall ist ein Tastgrad oder duty cycle des Heizstroms nahezu eins.

Anders ausgedrückt ist der von der Signalquelle bereitgestellte Eingangsstrom pulsförmig und somit breitbandig. Die Breite im Spektrum ist abhängig von der Flankensteilheit des Pulses. Der Gleichanteil wird herausgefiltert, wodurch die Pulsform im Zeitbereich nur vernachlässigbar beeinflusst wird. Im Vergleich zur Wiederholrate werden kurze Pulse erzeugt, beispielsweise 20-100 ns bei 1-5MHz Wiederholrate, da dies leicht zu erzeugen ist und damit auch Pulsmuster erzeugt werden können. Zum Beispiel werden fünf Pulse mit 20ns und jeweils 100ns Pause dazwischen mit dem Eingangsstrom bereitgestellt. Im Anschluss erfolgt eine Pause von z.B. 1µs bis die nächsten 5 Pulse gesendet werden.

Gemäß einer Weiterbildung weist die Pulserzeugungsvorrichtung eine Signaltrennvorrichtung auf, die dazu eingerichtet ist, den von der Signalquelle bereitgestellten Eingangsstrom von dem von der Heizquelle bereitgestellten Heizstrom elektrisch weitestgehend zu entkoppeln.

Die Signaltrennvorrichtung entkoppelt also den Eingangsstrom von dem Heizstrom, sodass sich ein Signalpfad, welcher hauptsächlich durch die Pulsverkürzungsschaltung gebildet wird, und ein Heizpfad ergibt. Eine Beeinflussung der Ströme in den beiden Pfaden ist somit weitestgehend unterbunden.

Gemäß einer Implementierung wird die Signaltrennvorrichtung durch eine geeignete Kombination eines Tiefpasses mit einem Hochpass realisiert. Beispielsweise wird der Heizstrom mittels einer geeignet dimensionierten Induktivität gefiltert, wohingegen das Ausgangssignal mit einer entsprechend dimensionierten Kapazität gefiltert wird. Alternativ zu den separaten Filtern in Form von Induktivität und Kapazität kann auch ein sogenanntes BiasT eingesetzt werden.

In einer weiteren Ausführungsform weist die Pulserzeugungsvorrichtung zusätzlich eine Regelungsschaltung auf. Die Regelungsschaltung ist mit der Heizquelle gekoppelt und zum Bereitstellen eines Steuersignals für die Heizquelle in Abhängigkeit einer Temperatur der Verzögerungsleitung eingerichtet.

Das Steuersignal steuert somit eine Höhe des von der Heizquelle bereitgestellten Heizstroms in Abhängigkeit der Temperatur auf der Verzögerungsleitung. Die Höhe des Heizstroms wird also erfindungsgemäß aktiv thermisch geregelt. Mit Vorteil ist die Pulsdauer der Ausgangspulse von sehr hoher Genauigkeit auch bei Temperaturschwankungen.

Gemäß einer Weiterbildung ist das Steuersignal in Abhängigkeit der Ausgangspulse, insbesondere in Abhängigkeit der Pulsdauer der Ausgangspulse bereitgestellt. Dabei bedingt insbesondere eine Verlängerung der Pulsdauer der Ausgangspulse eine Reduktion des Heizstroms.

Die erfindungsgemäße Regelung nutzt folglich die temperaturabhängige Veränderung in der Pulsdauer oder Pulsbreite der Ausgangspulse. Eine Erhöhung der Temperatur der Verzögerungsleitung bewirkt aufgrund der verlängerten Signallaufzeit eine Verlängerung der Pulsdauer der Ausgangspulse, also eine Verbreiterung dieser Pulse. Um einer zusätzlichen Erwärmung der Verzögerungsleitung, also einer Erwärmung auf oberhalb der nahezu konstanten Betriebstemperatur, zu begegnen, wird mithilfe des Steuersignals der Heizstrom in diesem Fall reduziert. Damit wird auf einfache Art und Weise eine thermische Regelung der Pulserzeugungsvorrichtung erreicht.

In einer Weiterbildung ist das Steuersignal in Abhängigkeit einer Verstärkung und einer Integration oder in Abhängigkeit der Verstärkung oder der Integration der Ausgangspulse bereitgestellt.

In einer alternativen Ausführungsform weist die Regelungsschaltung eine Messeinrichtung zum Erfassen der Temperatur der Verzögerungsleitung und eine mit der Messeinrichtung gekoppelte Signalerzeugungseinrichtung zur Erzeugung des Steuersignals auf. Dabei ist die Temperatur der Verzögerungsleitung mit einem Temperatursensor oder auf Basis einer Kapazitäts- oder Induktivitätsmessung oder einer Kombination aus Kapazitäts- und Induktivitätsmessung erfasst.

Alternativ oder zusätzlich zur oben geschriebenen Regelung auf Basis der Pulsbreite der Ausgangspulse kann die Temperatur der Verzögerungsleitung durch Messung bestimmt werden und das Steuersignal auf Basis der gemessenen Temperatur erzeugt werden. Dazu wird ein Temperatursensor eingesetzt oder die momentane Kapazität oder Induktivität der Leitung bestimmt.

Gemäß einer Weiterbildung liegt die zumindest im Wesentlichen konstante Betriebstemperatur der Verzögerungsleitung oberhalb einer maximalen Temperatur, die von den die Verzögerungsleitung umgebenden Komponenten der Pulserzeugungsvorrichtung einnehmbar ist.

Die Betriebstemperatur, auf die die Verzögerungsleitung mithilfe des Heizstroms aufgeheizt wird, liegt beispielsweise oberhalb von 50 Grad Celsius. Da die Betriebstemperatur oberhalb einer Temperatur liegt, die maximal von den übrigen Bauteilen der Pulserzeugungsvorrichtung, oder einer übergeordneten Schaltung, in welcher die Pulserzeugungsvorrichtung eingesetzt wird, angenommen werden kann, haben zusätzliche thermische Einflüsse oder Feuchtigkeitsveränderungen nahezu keine negative Auswirkung auf die Genauigkeit der Pulsdauer der von der erfindungsgemäßen Pulserzeugungsvorrichtung bereitgestellten Ausgangspulse.

In einer Weiterbildung umfasst die Verzögerungsleitung eines der folgenden Elemente oder eine Kombination dieser Elemente: eine Induktivität, eine Kapazität, eine Koaxialleitung, eine Leiterbahn, die sich auf oder in einer Leiterplatte befindet. Die Verzögerungsleitung ist dazu ausgelegt, einen Eingangspuls um eine voreingestellte Zeitdauer zu verzögern. Die voreingestellte Zeitdauer ist dabei in Abhängigkeit einer Temperatur der Verzögerungsleitung variabel.

Ein der Verzögerungsleitung zugeführter Eingangspuls wird beispielsweise nach Verzögerung um die voreingestellte Zeitdauer als Ausgangspuls bereitgestellt. Alternativ endet der Ausgangspuls nach der voreingestellten Zeitdauer (oder auch nach der doppelten voreingestellten Zeitdauer). Die voreingestellte Zeitdauer ist damit ein Nennwert der Verzögerung, die von der Verzögerungsleitung realisiert wird. Aufgrund der Temperaturabhängigkeit der Permittivität bzw. dielektrischen Leitfähigkeit schwankt die Zeitdauer bei Temperaturänderungen. Die erfindungsgemäße Pulserzeugungsvorrichtung begegnet diesem Effekt wie bereits beschrieben durch gleichzeitiges Verwenden der Verzögerungsleitung als Heizelement.

Gemäß einer Ausführungsform ist die Signalquelle elektrisch mit einem ersten Anschluss der Verzögerungsleitung gekoppelt, wobei der erste Anschluss der Verzögerungsleitung zugleich als Signalausgang für den Ausgangspuls dient. Ein zweiter Anschluss der Verzögerungsleitung kann mit einem Signalreflexionsmittel gekoppelt sein, wobei es sich bei dem Signalreflexionsmittel z.B. um einen Masseanschluss oder um ein offenes Leitungsende handeln kann. Dies bedeutet, es kann eine Reihenschaltung von Signalquelle, Verzögerungsleitung und Signalreflexionsmittel (in der genannten Reihenfolge) vorliegen.

Ein von der Signalquelle erzeugter Eingangspuls wird an dem ersten Anschluss in die Verzögerungsleitung eingespeist, wobei gleichzeitig der Eingangspuls als Ausgangspuls bereits am Signalausgang anliegt. Der Eingangspuls durchläuft dann die Verzögerungsleitung und wird am Signalreflexionsmittel reflektiert (insbesondere mit invertierter Phase), durchläuft nochmals die Verzögerungsleitung und löscht am ersten Anschluss den Eingangspuls aus, sodass der Ausgangspuls dann endet. Der Ausgangspuls besitzt in diesem Beispiel eine zeitliche Länge der doppelten voreingestellten Zeitdauer.

Das Signalreflexionsmittel kann beispielsweise durch ein geschlossenes Ende einer elektrischen Leitung gebildet sein, d.h. das Signalreflexionsmittel umfasst eine elektrische Verbindung auf ein Bezugspotential, insbesondere auf Masse. Hierzu kann ein Anschluss der Verzögerungsleitung, welcher dem mit der Signalquelle verbundenen Eingang der Verzögerungsleitung gegenüberliegt (d.h. der oben genannte zweite Anschluss), z.B. direkt mit Masse verbunden sein. Alternativ kann das Signalreflexionsmittel auch ein offenes Ende einer elektrischen Leitung umfassen, wobei der zweite Anschluss der Verzögerungsleitung insbesondere unbeschaltet bleiben kann oder mittels eines Widerstands von mehreren Megaohm, z.B. mit Masse verbunden wird.

Gemäß einer weiteren Ausführungsform umfasst die Pulsverkürzungsschaltung ein Logikgatter, insbesondere ein Exklusiv-Oder-Gatter (XOR). Ein erster Eingang des Logikgatters ist direkt mit der Signalquelle gekoppelt (erster Signalpfad), wohingegen ein zweiter Eingang des Logikgatters über die Verzögerungsleitung (zweiter Signalpfad) mit der Signalquelle elektrisch verbunden ist. Ein Ausgang des Logikgatters kann als Signalausgang dienen.

Für ein XOR-Gatter kann sich dann folgender Ablauf ergeben: Ein Eingangspuls wird sowohl in den ersten als auch in den zweiten Signalpfad eingespeist. Der erste Signalpfad weist dabei keine Verzögerungsleitung auf, weshalb der Eingangspuls nahezu instantan an dem ersten Eingang des Exklusiv-Oder-Gatters anliegt. Zu diesem Zeitpunkt liegt an dem zweiten Eingang des Exklusiv-Oder-Gatters noch kein Signal des Eingangspulses an, da der Eingangspuls in dem zweiten Signalpfad von der Verzögerungsleitung verzögert wird. Die Exklusiv-Oder-Bedingung des Exklusiv-Oder-Gatters ist somit erfüllt, weshalb das Exklusiv-Oder-Gatter "durchschaltet" und an seinem Ausgang ein Signal ausgibt. Nach der voreingestellten Zeitdauer (z.B. nach 2 ns) liegt der Eingangspuls auch an dem zweiten Eingang des Exklusiv-Oder-Gatters an. Die Exklusiv-Oder-Bedingung ist folglich nicht mehr erfüllt, weshalb nun an dem Ausgang des Exklusiv-ODER-Gatters kein Signal mehr ausgegeben wird. Im Ergebnis wird also an dem Ausgang des Exklusiv-Oder-Gatters für 2 ns ein Signal ausgegeben, d.h. es wird ein Ausgangspuls mit einer Pulsdauer von 2 ns erzeugt. Die Pulsdauer entspricht dabei der Verzögerungsdauer der Verzögerungsleitung. Der vorstehend erläuterte Vorgang läuft bei einer steigenden Flanke eines Eingangspulses ab. Auf entsprechende Weise wird auch bei einer fallenden Flanke eines Eingangspulses ein Ausgangspuls mit einer Pulsdauer erzeugt, die der Verzögerungsdauer der Verzögerungsleitung entspricht. Durch zusätzliches geeignetes Verknüpfen des Ausgangs des Exklusiv-ODER-Gatters mit dem Ausgang der Signalquelle in einem UND-Gatter oder einem Nicht-UND-Gatter kann dieser zweite Puls unterdrückt werden falls erforderlich.

Die von der Pulserzeugungsvorrichtung ausgegebenen Ausgangspulse weisen bevorzugt Logikpegel auf, dies bedeutet, dass die Spannung und/oder der Strom des jeweiligen Ausgangspulses mit Logikschaltungen kompatibel ist. Beispielsweise kann eine Kompatibilität mit TTL-Logik, mit CMOS-Logik oder mit Low-Voltage-CMOS-Logik implementiert sein. Insbesondere können die ausgegebenen Ausgangspulse (d.h. ein Ausgangssignal an dem Signalausgang) einen Spannungsbetrag z.B. zwischen 2 und 5 V, bevorzugt bis zu 5 V, besonders bevorzugt bis zu 3,3 V aufweisen. Alternativ sind auch Kleinspannungen möglich, insbesondere Spannungen mit einem Betrag bis 48 V oder 60 V und/oder Ausgangsströme von weniger als 20 A, bevorzugt von weniger als 10 A oder 5A, weiter bevorzugt von weniger als 500 mA, besonders bevorzugt von weniger als 20 mA.

In einer Ausführungsform weist eine Treiberschaltung eine Pulserzeugungsvorrichtung wie oben beschrieben, sowie eine Lasersignalquelle auf. Die Lasersignalquelle ist zum Erzeugen eines Treibersignals für eine Laserdiode eingerichtet. Das Treibersignal ist dabei eine Funktion der Ausgangspulse der Pulserzeugungsvorrichtung.

Die Treiberschaltung kommt beispielsweise in einem Laufzeitsensor, auch genannt time of flight sensor, zum Einsatz. Die von einer Laserdiode, die mit der erfindungsgemäßen Treiberschaltung betrieben wird, erzeugten Pulse werden vorteilhafterweise mit hoher Pulsdauergenauigkeit erzeugt. Dadurch kann eine, im Stand der Technik erforderliche, Reserve zur Augenschutzgrenze, die für eine bestimmte Laserklasse definiert ist, reduziert werden. Die durch die Erfindung ermöglichte höhere Sendeleistung trägt zu einer Verbesserung der Reichweite eines Messsystems, z.B. ein LiDar Sensor, in dem die Erfindung zum Einsatz kommt, bei und verbessert die Erkennbarkeit dunkler Ziele.

Weiterer Gegenstand der Erfindung ist ein Pulserzeugungsverfahren, welches folgende Schritte aufweist:
Erzeugen eines Eingangsstroms durch eine Signalquelle, wobei der Eingangsstrom Eingangspulse einer Eingangspulsdauer umfasst,
Heizen einer Verzögerungsleitung auf eine zumindest im Wesentlichen konstante Betriebstemperatur mittels eines Heizstroms,
Verkürzen der Eingangspulsdauer durch Verzögerung der Eingangspulse mittels der Verzögerungsleitung und Bereitstellen von Ausgangspulsen mit Pulsdauern im Bereich von Nanosekunden oder kürzer,
wobei eine Pulsdauer der Ausgangspulse kürzer als die Eingangspulsdauer ist.

Die in dem Pulserzeugungsverfahren eingesetzte Verzögerungsleitung wird erfindungsgemäß sowohl zur Verkürzung der Eingangspulsdauer als auch als Heizelement mit einer nahezu konstanten Betriebstemperatur eingesetzt. Dadurch ist mit Vorteil eine Genauigkeit der Pulsdauer der Ausgangspulse gegenüber dem Stand der Technik verbessert.

Im Übrigen gelten für das Verfahren die Ausführungen zur erfindungsgemäßen Pulserzeugungsvorrichtung entsprechend, dies gilt insbesondere hinsichtlich Vorteilen und Ausführungsformen.

Gemäß einer Realisierungsmöglichkeit wird das Pulserzeugungsverfahren mit der oben beschriebenen Pulserzeugungsvorrichtung implementiert.

Gemäß einer Weiterbildung erfolgt die Verzögerung der Eingangspulse in Abhängigkeit einer voreingestellten Zeitdauer, welche in Abhängigkeit einer Temperatur während der Verzögerung variabel ist.

In einer Weiterbildung weist das Pulserzeugungsverfahren zusätzlich ein Regeln einer Höhe des Heizstroms in Abhängigkeit einer Temperatur während der Verzögerung der Eingangspulse auf.

Die Erfindung wird nachfolgend beispielhaft anhand der Figuren näher erläutert. Funktions- beziehungsweise wirkungsgleiche Bauelemente und Schaltungsteile tragen gleiche Bezugszeichen. Es zeigen:
Figur 1 eine erste beispielhafte Ausführungsform der Pulserzeugungsvorrichtung wie vorgeschlagen,
Figur 2 eine zweite beispielhafte Ausführungsform der Pulserzeugungsvorrichtung wie vorgeschlagen,
Figur 3 eine dritte beispielhafte Ausführungsform der Pulserzeugungsvorrichtung wie vorgeschlagen,
Figur 4 eine vierte beispielhafte Ausführungsform einer Pulserzeugungsvorrichtung wie vorgeschlagen,
Figur 5 eine fünfte beispielhafte Ausführungsform einer Pulserzeugungsvorrichtung wie vorgeschlagen,
Figur 6 ein beispielhaftes Signaldiagramm,
Figur 7 eine sechste beispielhafte Ausführungsform der Pulserzeugungsvorrichtung wie vorgeschlagen, und
Figur 8 eine siebte beispielhafte Ausführungsform der Pulserzeugungsvorrichtung wie vorgeschlagen.

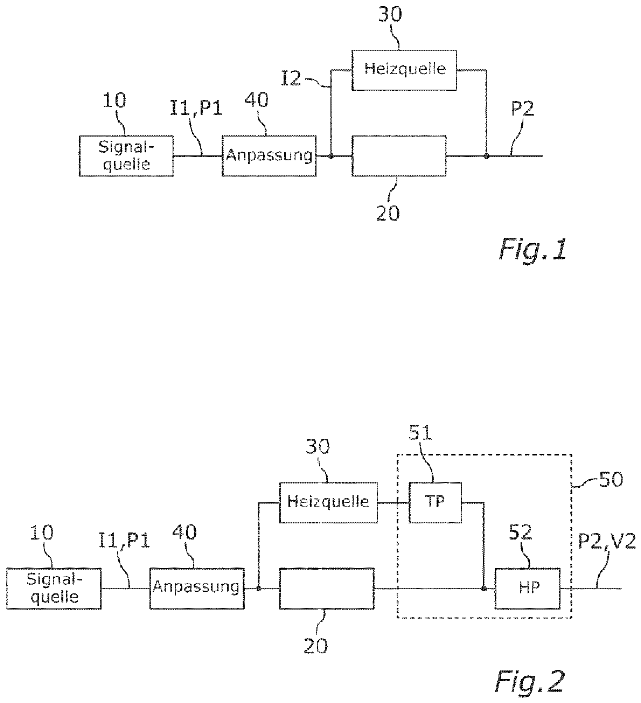

Figur 1 zeigt ein erstes Ausführungsbeispiel einer Pulserzeugungsvorrichtung wie vorgeschlagen in einer Blockschaltbilddarstellung. Die Pulserzeugungsvorrichtung umfasst eine Signalquelle 10 zum Bereitstellen eines Eingangsstroms I1, eine Pulsverkürzungsschaltung 20 und eine mit der Pulsverkürzungsschaltung 20 gekoppelte Heizquelle 30. Der von der Signalquelle 10 bereitgestellte Eingangsstrom I1 weist Eingangspulse P1, welche jeweils eine Eingangspulsdauer haben, auf. Die Pulsverkürzungsschaltung 20 umfasst eine Verzögerungsleitung und stellt Ausgangspulse P2 auf Basis des Eingangsstroms I1 bereit. Eine jeweilige Pulsdauer der Ausgangspulse P2 ist dabei kürzer als die Eingangspulsdauer der Pulse P1. Die Heizquelle 30 erzeugt einen Heizstrom I2. Mithilfe des Heizstroms I2 wird die Verzögerungsleitung der Pulsverkürzungsschaltung 20 auf eine zumindest im Wesentlichen beziehungsweise nahezu konstante Betriebstemperatur aufgeheizt. Die Heizquelle 30 ist hier rein beispielhaft und schematisch in Parallelschaltung zur Pulsverkürzungsschaltung 20 gezeigt. Andere Verschaltungen liegen im Bereich des fachmännischen Könnens.

Der von der Signalquelle 10 bereitgestellte Eingangsstrom I1 ist also ein zeitlich veränderliches Signal mit einer periodischen Schwingung und den Eingangspulsen P1. Optional umfasst die Pulserzeugungsvorrichtung ein Anpassungselement 40, welches in Serie zu der Signalquelle 10 und zu der Pulsverkürzungsschaltung 20 geschaltet ist. Alternativ kann das Anpassungselement 40 auch der Pulsverkürzungsschaltung 20 nachgeschaltet werden. Mithilfe des Anpassungselements 40 wird die Signalquelle 10 an einen Wellenwiderstand der Verzögerungsleitung der Pulsverkürzungsschaltung 20 angepasst, um Veränderungen der Signalform aufgrund von unerwünschten oder parasitären Reflexionen zu verhindern.

Die Heizquelle 30 umfasst beispielsweise eine nahezu ideale Stromquelle, welche sich ähnlich wie ein Leerlauf verhält und nahezu keinen Einfluss auf den von der Signalquelle 10 bereitgestellten Eingangsstrom I1 hat. Die Signalquelle 10 umfasst beispielsweise eine ideale Spannungsquelle, welche sich bei Deaktivierung wie ein Kurzschluss verhält. Ein ohmscher Verlust innerhalb der Verzögerungsleitung ist sehr viel kleiner als die Impedanz der Verzögerungsleitung, welche in etwa einem von dem Anpassungselement 40 realisierten Widerstand entspricht. Somit fließt ein großer Teil des Heizstroms I2 durch die Verzögerungsleitung, während der kleinere Teil über die Signalquelle 10 abfließt. Bei Realisierung der Signalquelle als ideale Spannungsquelle mit einem Serienwiderstand wie bei der Darstellung in Figur 1 angenommen, umfasst das Anpassungselement 40 einen weiteren Widerstand. Entspricht die Summe beider Widerstände dem Wellenwiderstand der Verzögerungsleitung, so ist eine Anpassung erreicht.

Figur 2 zeigt eine zweite beispielhafte Ausführungsform der Pulserzeugungsvorrichtung wie vorgeschlagen ebenfalls in Blockschaltbilddarstellung. Zusätzlich zur Schaltung der Figur 1 weist die Pulserzeugungsvorrichtung der Figur 2 eine Signaltrennvorrichtung 50 auf. Diese bewirkt eine weitestgehende Entkopplung des Eingangsstroms I1 von dem Heizstrom I2. Damit wird der Tatsache Rechnung getragen, dass die Heizquelle 30 nicht als ideale Stromquelle realisierbar ist.

Die Signaltrennvorrichtung 50 umfasst einen Tiefpass 51 und einen Hochpass 52. Der Hochpass 52 lässt zeitlich veränderliche Signale, also beispielsweise die Ausgangspulse P2, durch und dämpft den zeitlichen nicht oder nur sehr langsam veränderlichen Heizstrom I2. Der in Serie zur Heizquelle 30 geschaltete Tiefpass 51 verhindert, dass das zeitlich veränderliche Ausgangssignal V2 von der Heizquelle absorbiert wird. Die in Figur 2 dargestellte Ausführungsform der Signaltrennvorrichtung 50 entspricht dem oben beschriebenen BiasT.

Alternativ kann der Tiefpass 51 zwischen dem Anpassungselement 40 und der Heizquelle 30 angeordnet sein.

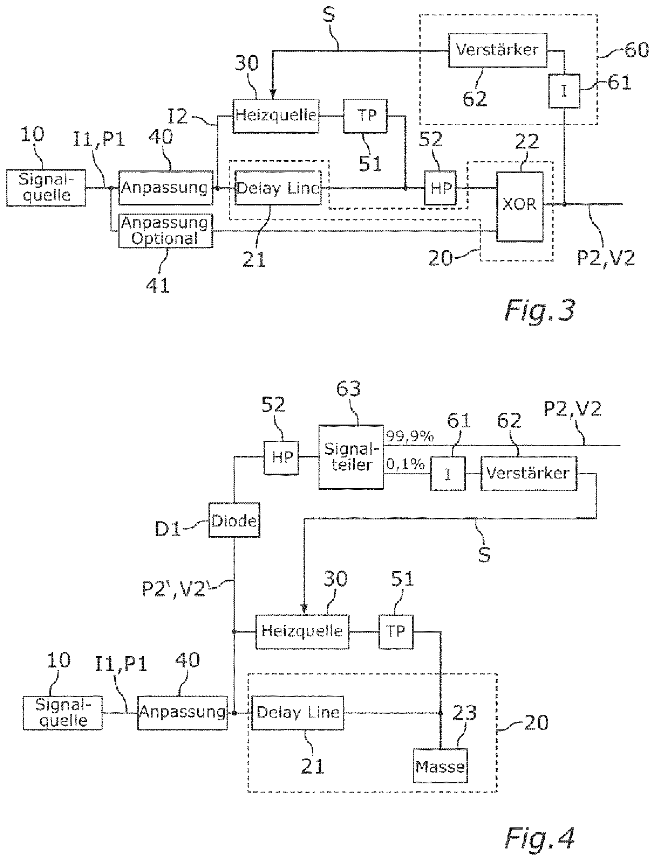

Figur 3 zeigt eine dritte beispielhafte Ausführungsform einer Pulserzeugungsvorrichtung wie vorgeschlagen ebenfalls in Blockschaltbilddarstellung. Zusätzlich zur Ausführungsform von Figur 2 umfasst dieses Ausführungsbeispiel eine Regelungsschaltung 60 wie dargestellt. Diese stellt ein Steuersignal S für die Heizquelle 30 bereit, um die Höhe des Heizstroms I2 einzustellen. Zudem ist die Pulsverkürzungsschaltung 20 detaillierter dargestellt. Sie umfasst die Verzögerungsleitung 21 und ein Logikgatter 22, welches hier beispielhaft als Exklusiv-Oder-Gatter, XOR-Gatter, ausgeführt ist.

Die Pulsverkürzungsschaltung 20 erzeugt aus den Eingangspulsen P1 die Ausgangspulse P2 mit gegenüber P1 verkürzter Pulsdauer folgendermaßen: Das Eingangssignal I1, also der Eingangsstrom I1, wird einmal direkt und einmal über die Verzögerungsleitung 21, also in verzögerter Form dem XOR-Gatter 22 zugeführt. Die am Ausgang des Gatters 22 bereitgestellten Ausgangspulse P2 haben eine Pulsdauer beziehungsweise Pulsbreite, die der Verzögerung auf der delay line 21 entspricht. Diese Verzögerung repräsentiert die voreingestellte Zeitdauer. Die voreingestellte Zeitdauer ist unter anderem abhängig von der aktuellen Temperatur auf der Verzögerungsleitung 21. Die Verzögerungsleitung 21 ist beispielsweise realisiert als in eine Leiterkarte integrierte Leitung. Mit einer 30cm langen Verzögerungsleitung wird beispielsweise eine Verzögerung von zwei Nanosekunden erzeugt. Eine Änderung der Temperatur der Verzögerungsleitung um 100 Kelvin verändert die Verzögerung beispielsweise um 100 Pikosekunden, was in etwa fünf Prozent des Nennwerts von zwei Sekunden entspricht.

Einer derartigen thermischen Schwankung der Signallaufzeit über die Verzögerungsleitung 21 wird durch das erfindungsgemäße Aufheizen der Verzögerungsleitung 21 auf die nahezu konstante Betriebstemperatur begegnet. Zusätzlich wird der Heizvorgang laufend nachgeregelt mit der Regelungsschaltung 60. Die Regelungsschaltung 60 integriert die Ausgangspulse P2 in einem Integrator 61 und verstärkt dessen Ausgangssignal im Verstärker 62. Der Integrator 61 weist dazu auch einen Reduzierer auf, welcher den Pegel des Ausgangssignals periodisch rücksetzt. Ein Pegel des Steuersignals S entspricht somit einer Pulsdauer der Ausgangspulse P2. Dieser Pegel spiegelt also die aktuellen Temperatureffekte oder andere Umwelteinflüsse wie Feuchtigkeit auf der Verzögerungsleitung 21 wieder.

Das Steuersignal S wird folglich dafür eingesetzt, den Heizstrom I2 zu erhöhen oder zu verringern bis die Ausgangspulse P2 wieder die gewünschte Pulsbreite annehmen.

Die Ausgangspulse P2 können als Spannungs- oder Strompulse betrachtet beziehungsweise bezeichnet werden. In der erfindungsgemäßen Pulserzeugungsschaltung werden Schwankungen der Pulsdauer der Ausgangspulse deutlich reduziert. Beispielsweise betragen die Schwankungen weniger als fünf Prozent bei 100 Kelvin.

Figur 4 zeigt eine vierte beispielhafte Ausführungsform einer Pulserzeugungsvorrichtung in Blockschaltbilddarstellung. Im Unterschied zur Ausführungsform von Figur 3 ist hier die Pulsverkürzungsschaltung 20 anders realisiert. Wie dargestellt umfasst die Pulsverkürzungsschaltung 20 die Verzögerungsleitung 21 und ein Signalreflexionsmittel 23. Das Signalreflexionsmittel 23 kann beispielsweise wie in Figur 4 angedeutet durch ein Massepotential realisiert sein. Die Pulsverkürzungsschaltung 20 arbeitet hier nach dem Reflexionsprinzip. Dabei durchläuft ein Eingangspuls P1 der Signalquelle 10, beispielsweise ein Spannungspuls P1, die Verzögerungsleitung 21, wird an dem Reflexionsmittel 23 mit invertiertem Vorzeichen reflektiert und durchläuft die Verzögerungsleitung 21 ein weiteres Mal in entgegengesetzter Richtung. Durch die teilweise zeitliche Überlappung eines Eingangspulses P1 mit seinem reflektierten und invertierten Pendant kommt es zu einer teilweisen Auslöschung des ursprünglichen Eingangspulses P1 und somit zu einem verkürzten vorläufigen Ausgangspuls P2'. Das auf diese Weise erhaltene vorläufigen Ausgangssignal V2' wird mit einer Diode D1 geglättet und über den Hochpassfilter 52 an einen Signalteiler 63 geleitet. Die Diode D1 filtert beispielsweise negative Pulse des vorläufigen Ausgangssignals V2', die durch das Ausschalten der Signalquelle 10 verursacht sein können, heraus. Ferner wird das vorläufige Ausgangssignal V2' erst ab einem bestimmten Niveau oder Spannungsniveau erfasst.

Der Signalteiler 63 teilt das vorläufige Ausgangssignal V2' so auf, dass der größte Teil, beispielsweise 99,9 %, als Ausgangssignal V2 bereitgestellt werden, und lediglich ein kleiner Teil, beispielsweise 0,1 % zur Erzeugung des Steuersignals S eingesetzt werden. Der Signalteiler 63 ist beispielsweise als hochohmiger Spannungsabgriff realisiert. Das Steuersignal S wird dann äquivalent zur Ausführungsform von Figur 3 mithilfe des Integrators 61 und des Verstärkers 62 erzeugt.

Die Verzögerungsleitung 21 besteht beispielsweise aus einer Kupferschicht und einem Basismaterial, beispielsweise FR4, und weist einen geringen Durchmesser auf. Damit eignet sie sich besonders gut als Heizelement.

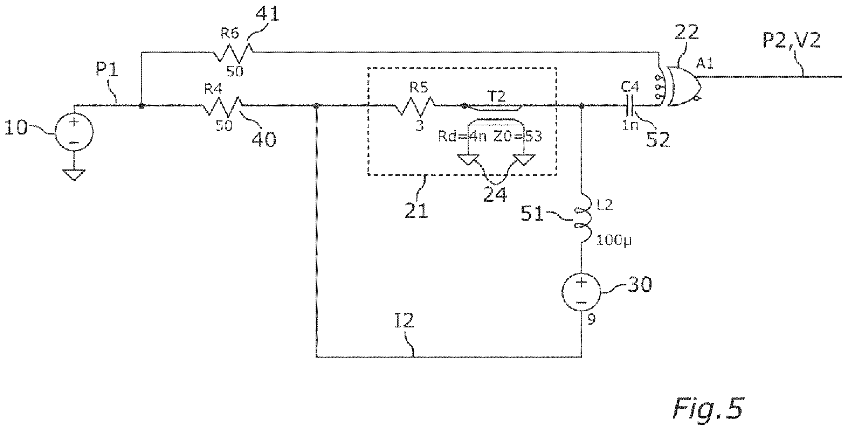

Figur 5 zeigt eine fünfte beispielhafte Ausführungsform einer Pulserzeugungsschaltung wie vorgeschlagen. Diese Ausführungsform zeigt eine mögliche schaltungstechnische Realisierung der in Figur 3 gezeigten dritten Ausführungsform, jedoch ohne die Regelungsschaltung 60. Die Signalquelle 10 ist als Spannungsquelle realisiert. Die angegebenen Dimensionierungen der Bauteile sind dabei rein beispielhaft zu verstehen. Jedes der Anpasselemente 40 und 41 ist als Widerstand R4 beziehungsweise R6 implementiert. Die Verzögerungsleitung 21 ist dargestellt als ein auf das Massepotenzial 24 bezogenes Verzögerungsglied T2 mit einem dazu in Reihe geschalteten Widerstand R5, welcher den ohmschen Verlust repräsentiert.

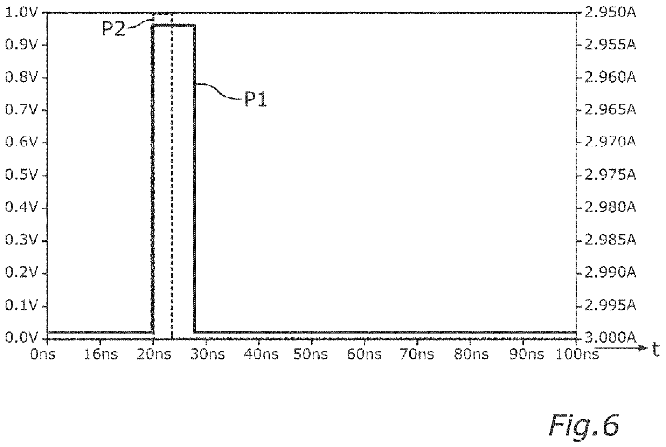

Figur 6 zeigt ein beispielhaftes Signaldiagramm zur Ausführungsform von Figur 5. Dargestellt ist der Verlauf des Stromes durch den Widerstand R5, welcher dem Eingangsstrom I1 weitestgehend entspricht und der Verlauf des Ausgangssignals V2 jeweils im Verhältnis zur Zeit t. Es ist zu erkennen, dass die Pulsdauer des Eingangspulses P1 in etwa halbiert wird und ein entsprechender Ausgangspuls P2 bereitgestellt wird.

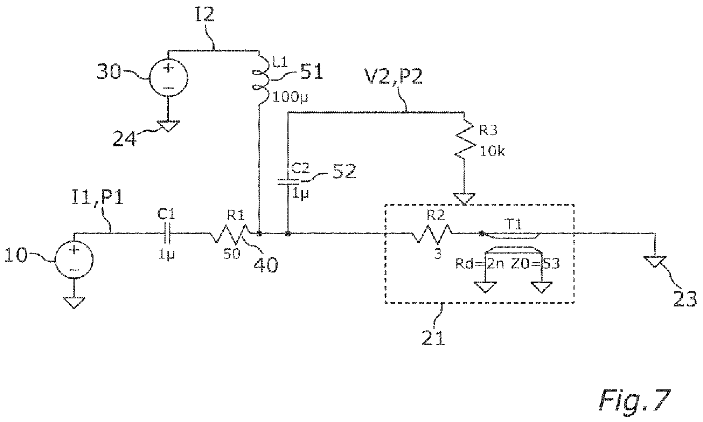

Figur 7 zeigt eine sechste beispielhafte Ausführungsform der Pulserzeugungsvorrichtung wie vorgeschlagen. Hier ist eine schaltungstechnische Beispielrealisierung passend zur vierten Ausführungsform aus Figur 4 dargestellt, wobei wieder die Regelungsschaltung weggelassen ist. Die verkürzten Ausgangspulse P2 werden also mittels zweifachen Durchlaufens der Verzögerungsleitung 21 und Reflexion am Reflexionsmittel 23 erzeugt.

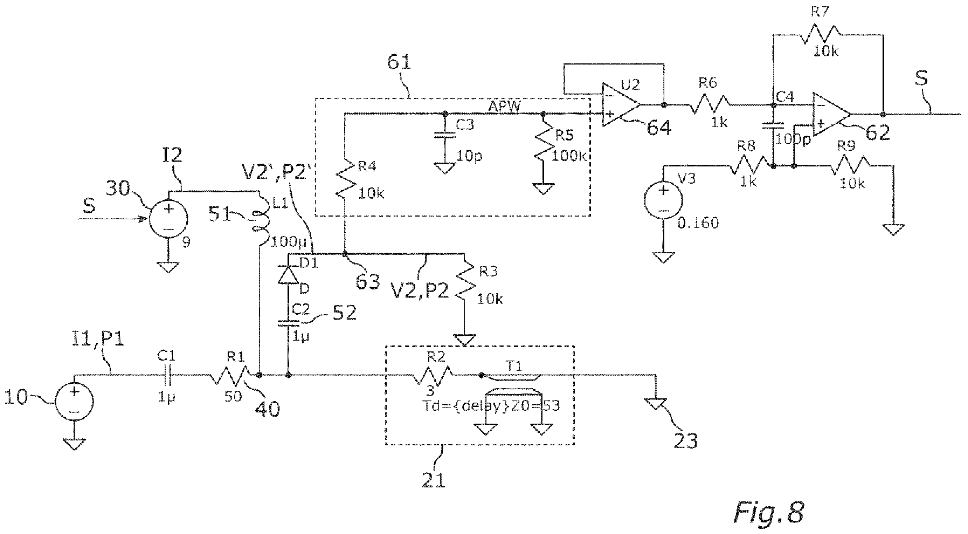

Figur 8 zeigt eine siebte beispielhafte Ausführungsform der Pulserzeugungsvorrichtung wie vorgeschlagen. Hier ist eine schaltungstechnische Realisierungsmöglichkeit der vierten Ausführungsform aus Figur 4 mitsamt der Regelungsschaltung dargestellt. Das vorläufige Ausgangssignal V2' wird also durch den Signalteiler 63, hier ein Knotenpunkt in der Schaltung, dem Integrator 61 zugeführt. Darin sorgt der Widerstand R5 für das oben beschriebene kontinuierliche Entladen. Am Ausgang des Integrators 61 erhält man nach Einschwingen der Schaltung einen Gleichspannungsoffset. Durch entsprechende Dimensionierung der Bauteile R4, C3 und R5 kann die Einschwingdauer reduziert werden. Dem Integrator 61 nachgeschaltet ist ein Spannungsfolger 64, sowie der Verstärker 62, hier ausgeführt als Differenzverstärker. Der Verstärker 62 kompensiert einen Teil des Offsets APW am Ausgang des Integrators 61 mittels der Spannungsquelle V3 und verstärkt das resultierende Signal, hier beispielsweise um den Faktor 10. Das am Ausgang des Verstärkers 62 bereitgestellte Steuersignal S ist in dieser Realisierung eine Festspannung, deren Höhe von der Pulsbreite der Ausgangspulse P2 abhängt. Mithilfe des Steuersignals S wird die Heizquelle 30 nachgeregelt.

Mit der vorgeschlagenen Pulserzeugungsvorrichtung können vorteilhafterweise neben Temperatureinflüssen auch andere Einflüsse wie zum Beispiel Bauteilstreuungen oder unterschiedliche Feuchtigkeit kompensiert werden.

Alternativ oder zusätzlich kann die vorgeschlagene Pulserzeugungsvorrichtung auch zur Überwachung verwendet werden. Dabei kann sie auch in Kombination mit einem Temperaturfühler für eine überwachte Regelung verwendet werden. Alternativ ist eine Kombination mit einer Kapazitäts- oder Induktivitätsmessung der Verzögerungsleitung 21 möglich.

### Bezugszeichenliste

- 10: Signalquelle
- 20: Pulsverkürzungsschaltung
- 21: Verzögerungsleitung
- 22: Logikgatter
- 23: Reflexionsmittel
- 24: Masseanschluss
- 30: Heizquelle
- 40, 41: Anpassungselement
- 50: Signaltrennvorrichtung
- 51: Tiefpass
- 52: Hochpass
- 60: Regelungsschaltung
- 61: Integrator
- 62: Verstärker
- 63: Signalteiler
- 64: Spannungsfolger
- P1, P2, P2': Puls
- S, I1, V2, V2': Signal
- D1: Diode
- R4, R5: Widerstand
- APW: Offset
- T2: Verzögerungsglied

## Patentansprüche

1. Pulserzeugungsvorrichtung zur Erzeugung von Ausgangspulsen (P2) mit Pulsdauern im Bereich von Nanosekunden oder kürzer aufweisend
eine Signalquelle (10) zum Bereitstellen eines Eingangsstroms (11), welcher Eingangspulse (P1) einer Eingangspulsdauer (P1) umfasst,
eine mit der Signalquelle (10) gekoppelte Pulsverkürzungsschaltung (20),
die eine Verzögerungsleitung (21) aufweist, und zum Bereitstellen der Ausgangspulse (P2) auf Basis des Eingangsstroms (I1) eingerichtet ist, wobei eine Pulsdauer der Ausgangspulse (P2) kürzer als die Eingangspulsdauer ist, **dadurch gekennzeichnet, dass** die Pulserzeugungsvorrichtung weiter aufweist:
eine mit der Pulsverkürzungsschaltung (20) gekoppelte Heizquelle (30) zum Bereitstellen eines Heizstroms (I2) für die Verzögerungsleitung (21) der Pulsverkürzungsschaltung (20),
wobei die Verzögerungsleitung (21) zum Aufheizen auf eine zumindest im Wesentlichen konstante Betriebstemperatur unter Verwendung des Heizstroms (I2) ausgelegt ist.

2. Pulserzeugungsvorrichtung nach Anspruch 1,
wobei eine Frequenz des Eingangsstroms (I1) höher ist als eine Frequenz des Heizstroms (I2),
wobei insbesondere die Heizquelle (30) eine Gleichstromquelle oder eine Gleichspannungsquelle umfasst.

3. Pulserzeugungsvorrichtung nach Anspruch 1 oder 2,
weiter aufweisend eine Signaltrennvorrichtung (50), die dazu eingerichtet ist, den von der Signalquelle (10) bereitgestellten Eingangsstrom (I1) von dem von der Heizquelle (30) bereitgestellten Heizstrom (I2) elektrisch weitestgehend zu entkoppeln.

4. Pulserzeugungsvorrichtung nach einem der vorstehenden Ansprüche, weiter aufweisend eine Regelungsschaltung (60), die mit der Heizquelle (30) gekoppelt ist und zum Bereitstellen eines Steuersignals (S) für die Heizquelle (30) in Abhängigkeit einer Temperatur der Verzögerungsleitung (21) eingerichtet ist.

5. Pulserzeugungsvorrichtung nach dem vorstehenden Anspruch,
wobei das Steuersignal (S) in Abhängigkeit der Ausgangspulse (P2), insbesondere in Abhängigkeit der Pulsdauer der Ausgangspulse (P2), bereitgestellt ist, wobei insbesondere eine Verlängerung der Pulsdauer der Ausgangspulse (P2) eine Reduktion des Heizstroms (I2) bedingt.

6. Pulserzeugungsvorrichtung nach Anspruch 4 oder 5,
wobei das Steuersignal (S) in Abhängigkeit einer Verstärkung und/oder Integration der Ausgangspulse (P2) bereitgestellt ist.

7. Pulserzeugungsvorrichtung nach Anspruch 4,
wobei die Regelungsschaltung (60) eine Messeinrichtung zum Erfassen der Temperatur der Verzögerungsleitung (21) und eine mit der Messeinrichtung gekoppelte Signalerzeugungseinrichtung zur Erzeugung des Steuersignals (S) aufweist,
wobei die Temperatur der Verzögerungsleitung (21) mit einem Temperatursensor oder auf Basis einer Kapazitäts- und/oder Induktivitätsmessung erfasst ist.

8. Pulserzeugungsvorrichtung nach einem der vorstehenden Ansprüche, wobei die zumindest im Wesentlichen konstante Betriebstemperatur der Verzögerungsleitung (21) oberhalb einer maximalen Temperatur liegt, die von den sie umgebenden Komponenten der Pulserzeugungsvorrichtung einnehmbar ist.

9. Pulserzeugungsvorrichtung nach dem einem der vorstehenden Ansprüche, wobei die Verzögerungsleitung (21) eine Induktivität und/oder eine Kapazität und/oder eine Koaxialleitung und/oder eine Leiterbahn auf oder in einer Leiterplatte umfasst und dazu ausgelegt ist, einen Eingangspuls (P1) um eine voreingestellte Zeitdauer zu verzögern, und
wobei die voreingestellte Zeitdauer in Abhängigkeit einer Temperatur der Verzögerungsleitung (21) variabel ist.

10. Treiberschaltung aufweisend
eine Pulserzeugungsvorrichtung nach dem einem der vorstehenden Ansprüche,
eine Lasersignalquelle zum Erzeugen eines Treibersignals für eine Laserdiode, wobei das Treibersignal eine Funktion der Ausgangspulse (P2) der Pulserzeugungsvorrichtung ist.

11. Pulserzeugungsverfahren aufweisend die folgenden Schritte:
Erzeugen eines Eingangsstroms (I1) durch eine Signalquelle (10), wobei der Eingangsstrom (I1) Eingangspulse (P1) einer Eingangspulsdauer umfasst,
**dadurch gekennzeichnet, dass** das Verfahren weiter aufweist:
Heizen einer Verzögerungsleitung (21) auf eine zumindest im Wesentlichen konstante Betriebstemperatur mittels eines Heizstroms (I2),
Verkürzen der Eingangspulsdauer durch Verzögerung der Eingangspulse (P1) mittels der Verzögerungsleitung (21) und Bereitstellen von Ausgangspulsen (P2) mit Pulsdauern im Bereich von Nanosekunden oder kürzer,
wobei eine Pulsdauer der Ausgangspulse (P2) kürzer als die Eingangspulsdauer (P1) ist.

12. Pulserzeugungsverfahren nach dem vorstehenden Anspruch
wobei die Verzögerung in Abhängigkeit einer voreingestellten Zeitdauer erfolgt, welche in Abhängigkeit einer Temperatur während der Verzögerung variabel ist.

13. Pulserzeugungsverfahren nach Anspruch 11 oder 12 weiter aufweisend: Regeln einer Höhe des Heizstroms (I2) in Abhängigkeit einer Temperatur während der Verzögerung der Eingangspulse (P1).

## Claims

1. A pulse generating device for generating output pulses (P2) with pulse durations in the range of nanoseconds or shorter, comprising
a signal source (10) for providing an input current (I1) which comprises input pulses (P1) of an input pulse duration (P1),
a pulse shortening circuit (20) which is coupled to the signal source (10),
which comprises a delay line (21) and which is configured to provide the output pulses (P2) on the basis of the input current (I1), wherein a pulse duration of the output pulses (P2) is shorter than the input pulse duration,
**characterized in that** the pulse generating device further comprises:
a heating source (30) coupled to the pulse shortening circuit (20) for providing a heating current (I2) for the delay line (21) of the pulse shortening circuit (20),
wherein the delay line (21) is designed to be heated to an at least substantially constant operating temperature using the heating current (I2).

2. A pulse generating device according to claim 1,
wherein a frequency of the input current (I1) is higher than a frequency of the heating current (I2),
wherein in particular the heating source (30) comprises a direct current source or a direct voltage source.

3. A pulse generating device according to claim 1 or 2,
further comprising a signal separation device (50) which is configured to electrically decouple the input current (I1) provided by the signal source (10) from the heating current (I2) provided by the heating source (30) to the greatest extent possible.

4. A pulse generating device according to any of the preceding claims,
further comprising a control circuit (60) coupled to the heating source (30) and configured to provide a control signal (S) for the heating source (30) as a function of a temperature of the delay line (21).

5. A pulse generating device according to the preceding claim,
wherein the control signal (S) is provided as a function of the output pulses (P2), in particular as a function of the pulse duration of the output pulses (P2), wherein in particular an increase in the pulse duration of the output pulses (P2) causes a reduction in the heating current (I2).

6. A pulse generating device according to claim 4 or 5,
wherein the control signal (S) is provided as a function of an amplification and/or integration of the output pulses (P2).

7. A pulse generating device according to claim 4,
wherein the control circuit (60) comprises a measuring device for detecting the temperature of the delay line (21) and a signal generating device coupled to the measuring device for generating the control signal (S), wherein the temperature of the delay line (21) is detected using a temperature sensor or on the basis of a capacitance and/or inductance measurement.

8. A pulse generating device according to any one of the preceding claims,
wherein the at least substantially constant operating temperature of the delay line (21) is above a maximum temperature which is attainable by the components of the pulse generating device that surround said delay line.

9. A pulse generating device according to any one of the preceding claims,
wherein the delay line (21) comprises an inductor and/or a capacitor and/or a coaxial line and/or a conductor track on or in a printed circuit board and is designed to delay an input pulse (P1) by a preset time duration, and
wherein the preset time duration is variable as a function of a temperature of the delay line (21).

10. A driver circuit comprising
a pulse generating device according to any one of the preceding claims,
a laser signal source for generating a drive signal for a laser diode, wherein the drive signal is a function of the output pulses (P2) of the pulse generating device.

11. A pulse generating method comprising the following steps:
generating an input current (I1) by a signal source (10), wherein the input current (I1) comprises input pulses (P1) of an input pulse duration,
**characterized in that** the method further comprises:
heating a delay line (21) to an at least substantially constant operating temperature by means of a heating current (I2),
shortening the input pulse duration by delaying the input pulses (P1) using the delay line (21) and providing output pulses (P2) with pulse durations in the range of nanoseconds or shorter,
wherein a pulse duration of the output pulses (P2) is shorter than the input pulse duration (P1).

12. A pulse generating method according to the preceding claim,
wherein the delay is performed as a function of a preset time duration which is variable as a function of a temperature during the delay.

13. A pulse generating method according to claim 11 or 12, further comprising:
regulating a magnitude of the heating current (I2) as a function of a temperature during the delay of the input pulses (P1).

## Revendications

1. Dispositif de génération d'impulsions destiné à générer des impulsions de sortie (P2) ayant des durées d'impulsion de l'ordre de la nanoseconde ou moins, comprenant
une source de signal (10) destinée à fournir un courant d'entrée (I1) comprenant des impulsions d'entrée (P1) d'une durée d'impulsion d'entrée (P1),
un circuit de raccourcissement d'impulsions (20) couplé à la source de signal (10), qui comprend une ligne à retard (21) et est agencé pour fournir les impulsions de sortie (P2) sur la base du courant d'entrée (I1), dans lequel une durée des impulsions de sortie (P2) est inférieure à la durée des impulsions d'entrée, **caractérisé en ce que** le dispositif de génération d'impulsions comprend en outre :
une source de chauffage (30) couplée au circuit de raccourcissement d'impulsions (20) pour fournir un courant de chauffage (I2) à la ligne à retard (21) du circuit de raccourcissement d'impulsions (20),
dans lequel la ligne à retard (21) est conçue pour être chauffée à une température de fonctionnement au moins sensiblement constante à l'aide du courant de chauffage (I2).

2. Dispositif de génération d'impulsions selon la revendication 1,
dans lequel une fréquence du courant d'entrée (I1) est supérieure à une fréquence du courant de chauffage (I2),
dans lequel la source de chauffage (30) comprend en particulier une source de courant continu ou une source de tension continue.

3. Dispositif de génération d'impulsions selon la revendication 1 ou 2, comprenant en outre un dispositif de séparation de signaux (50) qui est agencé pour découpler électriquement, dans la mesure du possible, le courant d'entrée (I1) fourni par la source de signal (10) du courant de chauffage (I2) fourni par la source de chauffage (30).

4. Dispositif de génération d'impulsions selon l'une des revendications précédentes,
comprenant en outre un circuit de régulation (60) qui est couplé à la source de chauffage (30) et qui est agencé pour fournir un signal de commande (S) à la source de chauffage (30) en fonction d'une température de la ligne à retard (21).

5. Dispositif de génération d'impulsions selon la revendication précédente, dans lequel le signal de commande (S) est fourni en fonction des impulsions de sortie (P2), en particulier en fonction de la durée des impulsions de sortie (P2), dans lequel un allongement de la durée des impulsions de sortie (P2) entraîne en particulier une réduction du courant de chauffage (I2).

6. Dispositif de génération d'impulsions selon la revendication 4 ou 5, dans lequel le signal de commande (S) est fourni en fonction d'une amplification et/ou d'une intégration des impulsions de sortie (P2).

7. Dispositif de génération d'impulsions selon la revendication 4,
dans lequel le circuit de régulation (60) comprend un dispositif de mesure pour détecter la température de la ligne à retard (21) et un dispositif de génération de signal couplé au dispositif de mesure pour générer le signal de commande (S),
dans lequel la température de la ligne à retard (21) est détectée à l'aide d'un capteur de température ou sur la base d'une mesure de capacité et/ou d'inductance.

8. Dispositif de génération d'impulsions selon l'une des revendications précédentes,
dans lequel la température de fonctionnement au moins sensiblement constante de la ligne à retard (21) est supérieure à une température maximale pouvant être atteinte par les composants entourant la ligne à retard du dispositif de génération d'impulsions.

9. Dispositif de génération d'impulsions selon l'une des revendications précédentes,
dans lequel la ligne à retard (21) comprend une inductance et/ou une capacité et/ou une ligne coaxiale et/ou une piste conductrice sur ou dans une carte de circuit imprimé et est conçue pour retarder une impulsion d'entrée (P1) d'une durée prédéfinie, et
dans lequel la durée prédéfinie est variable en fonction de la température de la ligne à retard (21).

10. Circuit d'attaque comprenant
un dispositif de génération d'impulsions selon l'une des revendications précédentes,
une source de signal laser pour générer un signal d'attaque pour une diode laser, dans lequel le signal d'attaque est fonction des impulsions de sortie (P2) du dispositif de génération d'impulsions.

11. Procédé de génération d'impulsions comprenant les étapes suivantes :
Générer un courant d'entrée (I1) par une source de signal (10), dans lequel le courant d'entrée (I1) comprend des impulsions d'entrée (P1) d'une durée d'impulsion d'entrée,
**caractérisé en ce que** le procédé comprend en outre :
chauffer une ligne à retard (21) à une température de fonctionnement au moins sensiblement constante au moyen d'un courant de chauffage (I2), raccourcir la durée des impulsions d'entrée en retardant les impulsions d'entrée (P1) au moyen de la ligne à retard (21) et fournir des impulsions de sortie (P2) ayant des durées d'impulsion de l'ordre de la nanoseconde ou moins,
dans lequel une durée des impulsions de sortie (P2) est plus courte que la durée des impulsions d'entrée (P1).

12. Procédé de génération d'impulsions selon la revendication précédente,
dans lequel le retard est effectué fonction d'une durée prédéfinie, qui varie en fonction d'une température pendant le retard.

13. Procédé de génération d'impulsions selon la revendication 11 ou 12, comprenant en outre :
réguler un niveau du courant de chauffage (I2) en fonction d'une température pendant le retard des impulsions d'entrée (P1).
